# EUROPEAN PATENT APPLICATION

(11) **EP 3 993 334 A1**
(43) Date of publication of application: **04.05.2022**
(21) Application number: 20834640.3
(22) Date of filing: 03.07.2020
(51) Int. Cl.: H04L 27/26

(54) **SIGNAL PROCESSING METHOD, APPARATUS AND DEVICE**

(30) Priority: 03.07.2019 CN 201910592687
(71) Applicant: ZTE Corporation, Shenzhen, Guangdong 518057 (CN)
(72) Inventor: HE, Haitao, Shenzhen, Guangdong 518057 (CN); WEI, Zhaobi, Shenzhen, Guangdong 518057 (CN); LI, Xiaofei, Shenzhen, Guangdong 518057 (CN); LI, Congwei, Shenzhen, Guangdong 518057 (CN)
(74) Representative: WBH Wachenhausen Patentanwälte PartG mbB
(86) International application number: PCT/CN2020/100248
(87) International publication number: WO 2021/000955

(57) **Abstract**

The embodiments of the present invention provide a signal processing method, apparatus and device, and a computer readable storage medium. Said method comprises: processing multiple types of bandwidth signals to be sent, to form multiple groups of standard bandwidth signals; filtering the multiple groups of standard bandwidth signals; and combining the filtered multiple groups of standard bandwidth signals and transmitting same. In the embodiments of the present invention, multiple types of bandwidth signals are processed to form multiple groups of standard bandwidth signals, so that a DUC/DDC can use uniform processing architecture which has high reusability and high flexible extensibility, reducing the processing complexity and design redundancy of the DUC/DDC, achieving a simpler and more consistent structure, and reducing the costs and heat consumption of a digital intermediate frequency chip.

## Description

### TECHNICAL FIELD

Embodiments of the present disclosure relate to, but are not limited to, a signal processing method, apparatus, and device, and a computer-readable storage medium.

### BACKGROUND

A single-carrier bandwidth of a current communications system ranges from 5 M to 400 MHz, or even wider. There are many types of bandwidths and a large number of carriers.

A multi-rate filtering technology based on software-defined radio and digital signal processing is used to process one carrier, and therefore a system structure is relatively simple. However, if a case of processing a multi-carrier multi-bandwidth signal, an enumeration design needs to be adopted to cover all possible carrier bandwidths, resulting in a complex structure, inflexible carrier configuration and severe design redundancy of a Digital Up Converter (DUC) or a Digital Down Converter (DDC) in a digital intermediate frequency technology. Moreover, in order to pursue higher bandwidth occupancy in the system, single-carrier large-bandwidth signals are uniformly processed in time domain, and a bandwidth of out-of-band (OOB) data is much smaller than that of a time domain sampling rate. In order to ensure a downward radiation template and an Adjacent Channel Power Ratio (ACPR), a filter order is very high (an order value of 512). If a Farrow architecture is used, adaptability and flexibility are high, but configuration and use are complex, design is complex, and large implementation resources are required.

Implementation of the requirement in hardware by an Application Specific Integrated Circuit (ASIC) chip leads to a large scale of a digital intermediate frequency chip with a significant cost and thermal consumption, which increases costs and thermal pressure to a Radio Remote Unit (RRU) or an Active Antenna Unit (AAU).

It's important to provide an effective solution in order to address the above problems.

### SUMMARY

The following is a summary of the subject matter described in detail herein. This summary is not intended to limit the scope of protection of the appended claims.

An embodiment of the present disclosure provides a signal processing method, apparatus and device, and a computer-readable storage medium.

An embodiment of the present disclosure provides a signal processing method, including: processing signals to be sent of various bandwidths into a plurality of groups of standard-bandwidth signals; separately filtering the plurality of groups of standard-bandwidth signals; and transmitting the plurality of groups of filtered standard-bandwidth signals after combination.

An embodiment of the present disclosure further provides a signal processing method, including: processing a received radio frequency signal into a plurality of groups of standard-bandwidth signals; separately filtering the plurality of groups of standard-bandwidth signals; demodulating a plurality of groups of bandwidth signals obtained by filtering; and scheduling and mapping a plurality of groups of demodulated signals obtained after demodulation.

An embodiment of the present disclosure further provides a signal processing apparatus, including: a first processing unit, configured to process signals to be sent of various bandwidths into a plurality of groups of standard-bandwidth signals; a first filtering unit, configured to separately filter the plurality of groups of standard-bandwidth signals; and a transmitting unit, configured to transmit the plurality of groups of filtered standard-bandwidth signals after combination.

An embodiment of the present disclosure further provides a signal processing apparatus, including: a second processing unit, configured to process a received radio frequency signal into a plurality of groups of standard-bandwidth signals; a second filtering unit, configured to separately filter the plurality of groups of standard-bandwidth signals; a demodulation unit, configured to demodulate a plurality of groups of bandwidth signals obtained by filtering; and a scheduling and mapping unit, configured to schedule and map a plurality of groups of demodulated signals obtained after demodulation.

An embodiment of the present disclosure further provides a signal processing device, including: a memory, a processor, and a computer program stored in the memory and executable by the processor, where the processor performs the signal processing methods when executing the computer program.

An embodiment of the present disclosure further provides a computer-readable storage medium storing computer-executable instructions, where the computer-executable instructions are configured to perform the signal processing methods.

An embodiment of the present disclosure includes: processing signals to be sent of various bandwidths into a plurality of groups of standard-bandwidth signals; separately filtering the plurality of groups of standard-bandwidth signals; transmitting the plurality of groups of filtered standard-bandwidth signals after combination. Embodiments of the present disclosure process a plurality of bandwidth signals into a plurality of groups of standard-bandwidth signals, so that a DUC/DDC can adopt a unified processing architecture with high reusability and flexible scalability, thereby easing processing and reducing design redundancy of the DUC/DDC, allowing the structures to be simpler and consistent, and reducing costs and thermal consumption of a digital intermediate frequency chip.

Other aspects according to the present disclosure may be apparent from reading and understanding the accompanying drawings and detailed description.

### BRIEF DESCRIPTION OF DRAWINGS

Fig. 1 is a flowchart of a signal processing method according to an embodiment of the present disclosure (applied to a downlink transmission link);
Fig. 2 is a flowchart of step 201 according to an embodiment of the present disclosure;
Fig. 3 is an overall processing flowchart of a transmit-link data stream according to an application example of the present disclosure;
Fig. 4 is a block diagram of a digital intermediate frequency processing architecture system according to an application example of the present disclosure (a transmission link);
Fig. 5 is a block diagram of processing of a 100 MHz bandwidth carrier according to an application example of the present disclosure;
Fig. 6 is a flowchart of a signal processing method according to an embodiment of the present disclosure (applied to an uplink transmission link);
Fig. 7 is an overall processing flowchart of a receive-link data stream according to an application example of the present disclosure;
Fig. 8 is a block diagram of a digital intermediate frequency processing architecture system according to an application example of the present disclosure (a receive link);
Fig. 9 is a schematic diagram of composition of a signal processing apparatus according to an embodiment of the present disclosure (applied to a downlink transmission link); and
Fig. 10 is a schematic diagram of composition of a signal processing apparatus according to an embodiment of the present disclosure (applied to an uplink transmission link).

### DETAILED DESCRIPTION

The embodiments of the present disclosure will be described in detail below with reference to the accompanying drawings.

The steps shown in the flowcharts of the drawings may be performed in a computer system, such as with a set of computer-executable instructions. Moreover, although a logical order is shown in the flowcharts, the steps shown or described may be performed, in some cases, in a different order than shown or described herein.

The embodiments of the present disclosure adopt a Filter Bank to realize flexible configuration and replacement of an Occupied Bandwidth (OBW) and a carrier number/carrier bandwidth, so as to realize high reusability and high flexible scalability of a scheme architecture. Same Filter Bank bandwidth division processing may be performed on New Radio (NR) and Long Term Evolution (LTE) signals within the OBW. This architecture is uniform and simple. If a plurality of possible bandwidth divisions are compatible, adjustment is required for a small bandwidth. During processing, the small bandwidth only needs to be stretched and aligned to a standard bandwidth in the Filter Bank at low cost.

The embodiments of the present disclosure can be applied to a simplified design method for an Orthogonal Frequency Division Multiplexing (OFDM) modulated signal, a physical-layer Fast Fourier Transform (FFT)/Inverse Fast Fourier Transform (IFFT) and a digital intermediate frequency processing DUC/DDC processing link in all base station types (and can also be extended to User Equipment (UE)), transmitters or receivers in the field of wireless communications technologies. The embodiments can be further applied to a Wireless Fidelity (Wi-Fi) system, a microwave system, and other systems.

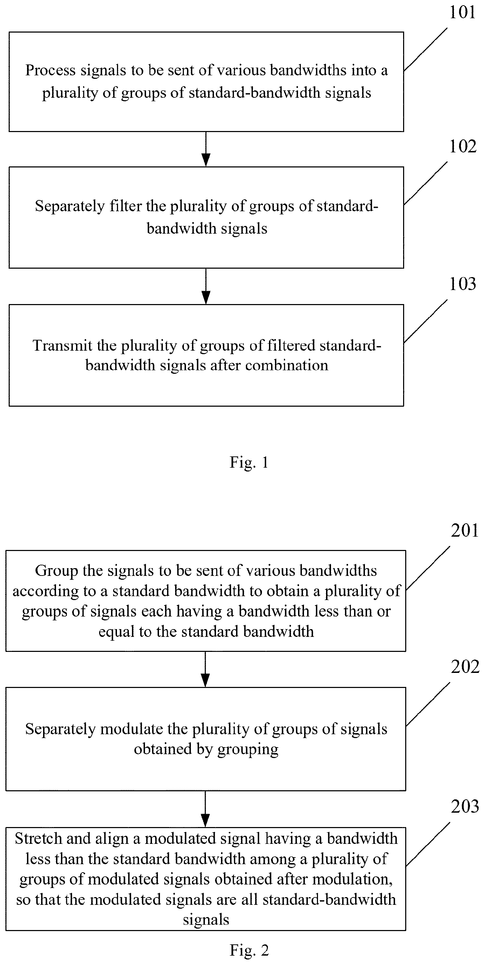

As shown in Fig. 1, a signal processing method according to an embodiment of the present disclosure is applied to a downlink transmission link, including the following steps.

At step 101, signals to be sent of various bandwidths are processed into a plurality of groups of standard-bandwidth signals.

In an implementation, the standard bandwidth is a preset specified bandwidth, which can be selected according to the actual situation. For example, 20 M can be set as the standard bandwidth.

In an implementation, as shown in Fig. 2, step 101 may include the following steps.

At step 201, the signals to be sent of various bandwidths are grouped according to the standard bandwidth to obtain a plurality of groups of signals each having a bandwidth less than or equal to the standard bandwidth.

In this step, a Resource Block (RB) with large bandwidths in frequency domain that exceed the standard bandwidth can be scheduled and grouped according to the standard bandwidth.

A signal with a bandwidth less than the standard bandwidth may be a signal with an original bandwidth less than the standard bandwidth, or a signal with a bandwidth less than the standard bandwidth remaining after a signal with a bandwidth greater than the standard bandwidth has been grouped.

At step 202, the plurality of groups of signals obtained by grouping are separately modulated.

In this step, OFDM modulation is performed on the plurality of groups of signals.

In an embodiment, the step 202 includes performing IFFT and Cyclic Prefix (CP) addition on the plurality of groups of signals obtained by grouping.

In an embodiment, a number of IFFT points used to perform the IFFT is 1024 points or 2048 points.

In this step, the number of IFFT points is consistent, and the number of IFFT points is reduced greatly from a traditional large number of IFFT points (for example, 4096) to multiple sets of small numbers of IFFT points (for example, 1024 or 2048), to reduce an amount of FFT butterfly operation.

At step 203, a modulated signal having a bandwidth less than the standard bandwidth among a plurality of groups of modulated signals obtained after modulation is stretched and aligned, so that the modulated signals are all standard-bandwidth signals.

In an embodiment, that a modulated signal having a bandwidth less than the standard bandwidth is stretched and aligned includes performing an interpolation operation on the modulated signal having a bandwidth less than the standard bandwidth, to reach a sampling rate of the standard bandwidth.

At step 102, the plurality of groups of standard-bandwidth signals are separately filtered.

In an implementation, filtering is a process of grouping and formation, and this step realizes multi-group signal formation and interpolation for a rate variation.

In an embodiment, step 102 includes separately filtering the plurality of groups of standard-bandwidth signals by using filter banks, where a first filter bank is used for a standard-bandwidth signal at a boundary of a frequency band, a second filter bank is used for a standard-bandwidth signal in the middle of the frequency band, and the first filter bank and the second filter bank include filters of the same type.

The filter bank may include a Finite Impulse Response (FIR) filter, a half-band filter, a Cascaded Integrator Comb (CIC) filter, a fraction times filter, and the like.

The FIR filter may be a Raised Cosine Filter (RCF).

A coefficient (order) of the FIR filter can be reconfigured by software. In other words, the first filter bank and the second filter bank can use same filters on hardware with different coefficients configured by software, thereby simplifying a design and saving costs.

In an embodiment, an order of an FIR filter in the first filter bank is higher than an order of an FIR filter in the second filter bank.

For example, an order of an FIR filter in the first filter bank is 254, and an order of an FIR filter in the second filter bank is 80.

In an embodiment, the standard-bandwidth signal in the middle of the frequency band is processed by using the second filter bank in a time-domain windowing manner. In an implementation, time-domain windowing means a dot product of a raised cosine window or another common window function in another FIR in time domain, to realize smoothness between different symbols and effectively inhibit out-of-band diffusion.

Step 102 completes formation and interpolation for a rate variation of the plurality of groups of signals. In addition, in order to ensure a radio frequency index, a bank at the boundary of the frequency band uses a high-order filter to ensure a radiation template requirement and an ACPR requirement at the near end, and a plurality of banks located in the middle use low-order filters or perform time-domain windowing processing to ensure an ACPR requirement at the far end of a large-bandwidth signal combined by the plurality of groups of signals.

At step 103, the plurality of groups of filtered standard-bandwidth signals are transmitted after combination.

In an embodiment, before step 103, the method further includes arranging the plurality of groups of filtered standard-bandwidth signals in an air-interface frequency point relationship to restore frequency-domain positions of the signals to be sent of various bandwidths.

At step 103, the signals can be transmitted to an air interface via a Digital to Analog Converter (DAC), a digital up converter, radio frequency, a Power Amplifier (PA), and an antenna, to complete an entire data stream processing process of an RRU/AAU.

In the embodiment of the present disclosure, the plurality of bandwidth signals are processed into the plurality of groups of standard-bandwidth signals, so that a DUC/DDC can adopt a unified processing architecture with high reusability and flexible scalability, thereby easing processing and reducing design redundancy of the DUC/DDC, making a structure simpler and more consistent, and reducing costs and thermal consumption of a digital intermediate frequency chip.

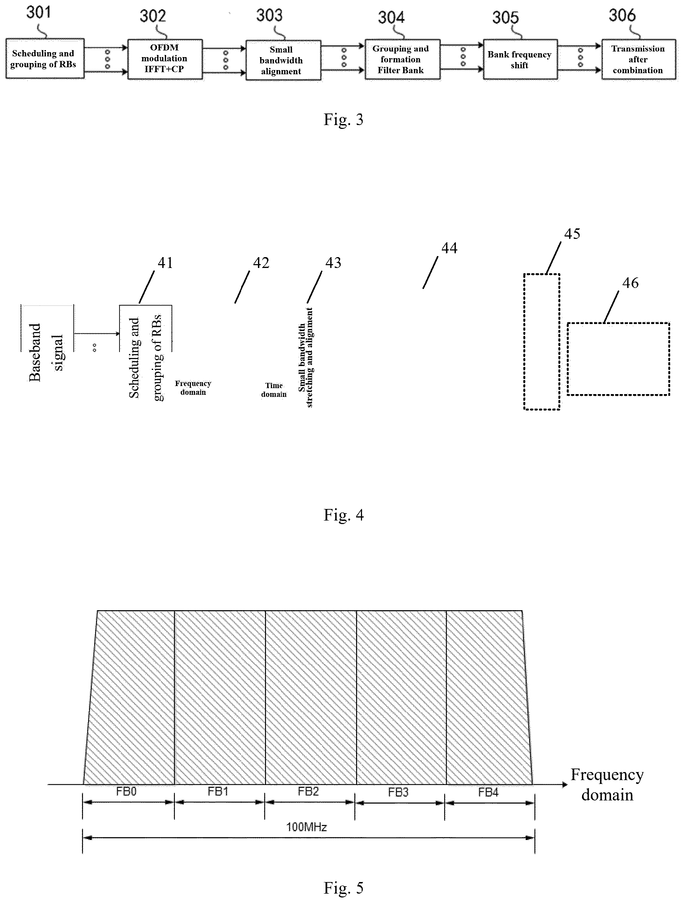

As shown in Fig. 3, an overall processing procedure of a transmit-link data stream of a base station is used as an example for description, and the procedure includes the following steps.

At step 301, RBs are scheduled and grouped.

In this step, a used RBs scheduling and grouping module is a PHY (physical) layer grouping and preprocessing module, which schedules and groups large-bandwidth signals in frequency domain exceeding a standard bandwidth. A group of large-bandwidth RBs is divided into a plurality of groups of RBs, which corresponds to a plurality of groups of Banks.

At step 302, OFDM modulation is performed.

A downlink IFFT and time-domain CP addition are performed on a signal having a bandwidth less than or equal to the standard bandwidth after grouping. A number of IFFT points is consistent, and the number of IFFT points is reduced exponentially from a traditional large number of IFFT points to a plurality of small numbers of IFFT points, to reduce an amount of FFT butterfly operations.

At step 303, small bandwidth alignment is performed.

In order to solve a problem that a signal having a bandwidth larger than the standard bandwidth may not be divided into standard-bandwidth signals exponentially, and to solve a problem that different operators have requirements for bandwidths less than the standard bandwidth, several small bandwidth processing modules can be configured to performing interpolation by using the small bandwidth as an interpolation multiple, to reach a sampling rate of the standard bandwidth, and complete small bandwidth stretching and alignment. Then, signals obtained after alignment are sent to a corresponding Filter Bank standard module in the following step 304.

At step 304, grouping and formation are performed.

This step completes formation and interpolation for a rate variation of the plurality of banks of signals. In addition, in order to ensure a radio frequency index, a bank at a boundary of a frequency band uses a high-order filter to ensure a radiation template requirement and an ACPR requirement at the near end, and a plurality of banks located in the middle of the frequency band use low-order filters or perform time-domain windowing processing to ensure an ACPR requirement at the far end of a large-bandwidth signal combined by the plurality of banks.

At step 305, bank frequency shift is performed.

In this step, a frequency-domain position of the original large-bandwidth signal is restored, and RBs in the plurality of banks are arranged in an air-interface frequency point relationship.

At step 306, transmission after combination is performed.

An original requirement of restoring the large-bandwidth signal by using the plurality of banks is not visible to UE. The signals are transmitted to an air interface through a DAC, a digital up converter, radio frequency, a PA amplifier, and an antenna, to complete an entire data stream processing process of an RRU/AAU.

Fig. 4 is a block diagram of a digital intermediate frequency processing architecture system corresponding to the procedure in Fig. 3. It can be seen from Fig. 4 that, although bandwidths required by the system are quite diverse, Filter Bank processing is simple and uniform. In this example, a standard bandwidth is 20 MHz. In other embodiments, a bandwidth of another value can be used as the standard bandwidth. If a conventional method is used, a 100 MHz bandwidth and a 30 kHz Subcarrier Spacing (SCS) are formed at 153.6 MSPS, a number of IFFT points is 5120, and an FIR filter formation order is 510. According to the method in this embodiment of the present disclosure, a single filter bank (Filter Bank) uses five bands of 20 MHz and a 30.72 MSPS sampling rate, and a number of IFFT points is 1024. In an implementation, an FIR filter order in a first filter bank is 254, and an FIR filter order in a second filter bank is 80 or time-domain windowing is performed, which greatly reduces an amount of multiplication and addition operations.

An RBs scheduling and grouping module 41 is a PHY-layer grouping and preprocessing module, which is configured to schedule and group a baseband signal with a large frequency-domain bandwidth (a large bandwidth means exceeding the standard bandwidth), for example, to divide a 100 MHz single-carrier bandwidth into five 20 MHz standard Bank groups. 273 effective RBs are divided into [54, 55, 55, 55, 54], corresponding to 5 filter banks (Filter Bank).

An OFDM modulation module 42 is configured to perform downlink IFFT and time-domain CP addition on the 20 MHz standard signal obtained after grouping. The number of IFFT points is consistent, and the number of IFFT points is changed from the traditional 5120 points to 5 sets of 1024 points.

A small-bandwidth stretching and alignment module 43 is configured to stretch and align a modulated signal having a bandwidth less than the standard bandwidth, so that the modulated signals are all standard-bandwidth signals. A bypass can be used herein.

A grouping and formation module 44 is configured such that frequency-domain left and right boundaries - two 20 MHz Banks (a FBO and a FB4 in Fig. 5) use high-order filters to ensure a radiation template requirement and an ACPR requirement at the near end. Three 20 MHz banks in the middle use low-order filters or perform time-domain windowing processing to ensure an ACPR requirement at the far end of a large-bandwidth signal combined by the plurality of banks.

In this example, the grouping and formation module 44 includes an RCF and a DUC, where the RCF is used for filtering, and the DUC is configured to implement an interpolation operation. As shown in Fig. 4, the DUC realizes two times of interpolation and three times of interpolation.

A bank frequency shift module 45 is configured to arrange the five 20 MHz banks in the frequency-domain relationship shown in Fig. 4.

In this example, the bank frequency shift module 45 can be implemented through a Numerically Controlled Oscillator (NCO).

A transmission after combination module 46 is configured such that, an original requirement of restoring the large-bandwidth signal by using the five 20 MHz banks is not visible to UE; the signals are transmitted to an air interface through a DAC, a digital up converter, radio frequency, a PA amplifier, and an antenna, to complete an entire data stream processing process of an RRU/AAU. The frequency domain is shown in Fig. 5, in which the 3 banks in the middle have no boundary and are seamless; the 2 banks on both sides have boundaries, with different effective bandwidths and occupied bandwidths.

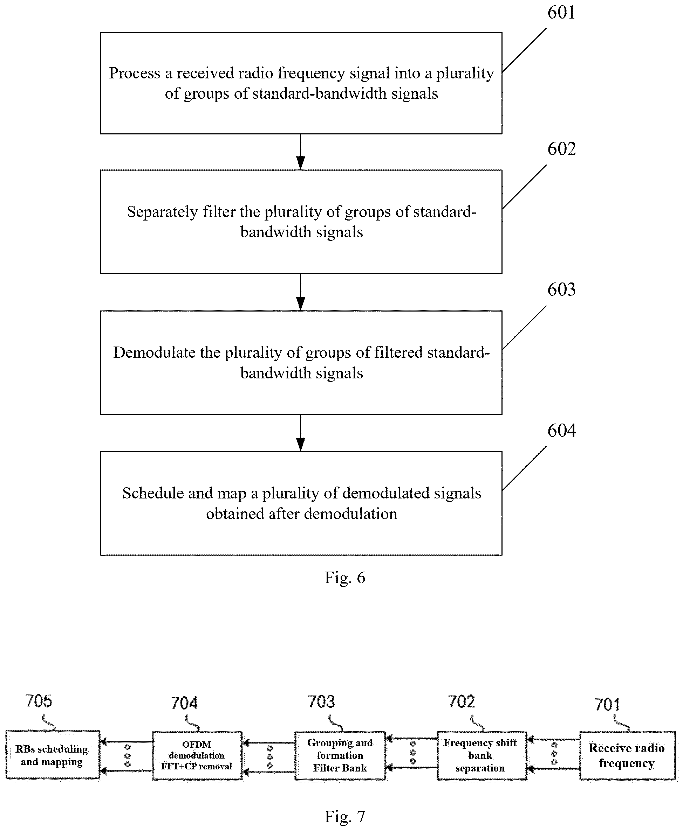

As shown in Fig. 6, a signal processing method according to an embodiment of the present disclosure is applied to an uplink transmission link, including the following steps.

At step 601, a received radio frequency signal is processed into a plurality of groups of standard-bandwidth signals.

In an embodiment, step 601 includes performing sampling and digitization on the radio frequency signal, and dividing the radio frequency signal according to a standard bandwidth to obtain the plurality of groups of standard-bandwidth signals.

In an implementation, a receiver side may include a receiving radio frequency link, an antenna, a low-noise amplifier, a radio frequency link, a digital down converter, and an Analog-to-Digital Converter (ADC), to complete sampling and digitization of the radio frequency signal.

In this step, a signal having a bandwidth larger than the standard bandwidth is divided in frequency domain according to the standard bandwidth, and each group is shifted to a digital 0 frequency.

At step 602, the plurality of groups of standard-bandwidth signals are separately filtered.

In an implementation, filtering is a process of grouping and formation, and this step realizes multi-group signal formation and extraction for a rate variation.

In an embodiment, step 602 includes separately filtering the plurality of groups of standard-bandwidth signals by using filter banks, where a first filter bank is used for a standard-bandwidth signal at a boundary of a frequency band, a second filter bank is used for a standard-bandwidth signal in the middle of the frequency band, and the first filter bank and the second filter bank include filters of the same type.

The filter bank may include an FIR filter, a half-band filter, a CIC filter, a fraction times filter, and the like.

The FIR filter may be an RCF.

In an embodiment, an order of an FIR filter in the first filter bank is higher than an order of an FIR filter in the second filter bank.

For example, an order of an FIR filter in the first filter bank is 254, and an order of an FIR filter in the second filter bank is 80.

In an embodiment, the standard-bandwidth signal in the middle of the frequency band is processed by using the second filter bank in a time-domain windowing manner.

Step 602 completes formation and extraction for a rate variation of the plurality of groups of signals. In addition, in order to ensure a radio frequency index, a bank at the boundary of the frequency band uses a high-order filter to ensure a blocking requirement and an Adjacent Channel Selectivity (ACS) requirement at the near end, and a plurality of banks located in the middle use low-order filters or perform time-domain windowing processing to ensure a blocking requirement at the far end.

At step 603, a plurality of groups of bandwidth signals obtained by filtering are demodulated.

In an embodiment, before step 603, the method further includes: among the plurality of groups of bandwidth signals obtained by filtering, extracting and processing a bandwidth signal that has been stretched and aligned, to obtain a signal with a bandwidth less than the standard bandwidth.

In an embodiment, step 603 includes performing CP removal and an FFT on the plurality groups of bandwidth signals obtained by filtering.

In an embodiment, a number of FFT points used to perform the FFT is 1024 points or 2048 points.

In this embodiment, the number of FFT points is consistent, and the number of FFT points is reduced exponentially from a traditional large number of FFT points to a plurality of small numbers of FFT points.

At step 604, a plurality of groups of demodulated signals obtained after demodulation are scheduled and mapped.

In this step, RBs in the plurality of filter banks are mapped and combined into a group of effective RBs according to a protocol and an actual air interface correspondence.

As shown in Fig. 7, an overall processing procedure of an uplink receiving link data stream of a base station is used as an example for description, and the procedure includes the following steps.

At step 701, a radio frequency signal is received.

In an implementation, a receiving radio frequency link may include an antenna, a low-noise amplifier, a radio frequency link, a digital down converter, and an ADC, to complete sampling and digitization of the radio frequency signal.

At step 702, frequency shift bank separation is performed.

A large-bandwidth signal received from UE is divided into Banks in frequency domain, and each Bank is shifted to a digital 0 frequency.

At step 703, grouping and formation are performed.

Formation and extraction for a rate variation of a plurality of banks are completed. In addition, in order to ensure a radio frequency index, a bank at a boundary of a frequency band uses a high-order filter to ensure a blocking requirement and an ACS requirement at the near end, and a plurality of banks located in the middle use low-order filters or perform time-domain windowing processing to ensure a blocking requirement at the far end.

At step 704, OFDM demodulation is performed.

CP removal and an FFT are performed on small-bandwidth signals obtained after grouping. A number of FFT points is consistent, and the number of FFT points is reduced exponentially from a traditional large number of FFT points to a plurality of small numbers of FFT points.

At step 705, RBs scheduling and mapping are performed.

Scheduling and frequency-domain position mapping functions of the separated Bank to large-bandwidth frequency-domain RBs are completed.

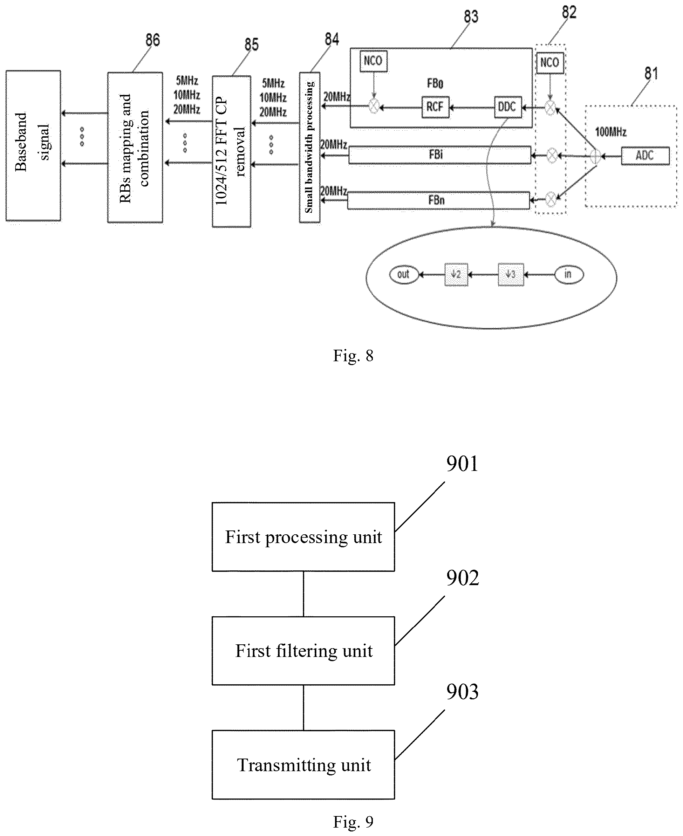

Fig. 8 is a block diagram of a digital intermediate frequency processing architecture system corresponding to the procedure in Fig. 7. A 100 MHz system is used as an example. If a conventional method is used, a 100 MHz bandwidth and a 30 kHz SCS are formed at 153.6 MSPS, a number of FFT points is 5120, and an FIR filter formation order is 510. If this method is used, a single filter bank (Filter Bank) uses five bands of 20 MHz and a 30.72 MSPS sampling rate, and a number of FFT points is 1024. In an implementation, an FIR filter order in a first filter bank is 254, and an FIR filter order in a second filter bank is 80 or time-domain windowing is performed, which greatly reduces an amount of multiplication and addition operations.

A receiving module 81 is configured to receive a 100 MHz signal through the antenna, and the signal is processed by the low-noise amplifier, the radio frequency, the digital down converter, and the ADC, to complete an entire data stream analog processing process and analog conversion of an RRU/AAU.

A bank frequency shift module 82 is configured to shift frequencies of five 20 MHz banks to the digital 0 frequency according to an air-interface frequency relationship shown in Fig. 4.

In this example, the bank frequency shift module 82 can be implemented through a Numerically Controlled Oscillator (NCO).

A grouping and formation module 83 is configured such that, frequency-domain left and right boundaries - two 20 MHz Banks (a FBO and a FB4 in Fig. 5) use high-order filters to ensure an ACS requirement and an in-band blocking requirement at the near end; three 20 MHz banks in the middle use low-order filters or perform time-domain windowing processing to ensure an in-band blocking requirement at the far end.

In this example, the grouping and formation module 83 includes an RCF and a DDC, where the RCF is used for filtering, and the DDC is configured to implement an extraction operation. As shown in Fig. 8, the DDC realizes two times of extraction and three times of extraction.

A small-bandwidth processing module 84 is configured to extract and process some bandwidth signals in standard-bandwidth signals obtained by the grouping and formation module 83 to obtain a signal with a bandwidth less than the standard bandwidth. A bypass can be used herein.

An OFDM demodulation module 85 is configured to perform time-domain CP removal and an uplink FFT on the 20 MHz standard signal obtained after grouping. The number of FFT points is consistent, and the number of FFT points is changed from the traditional 5120 points to 5 sets of 1024 points.

An RBs mapping and combination module 86 is a PHY-layer grouping and processing module, and is configured to splice small-bandwidth RBs in frequency domain into baseband signals of large-bandwidth single-carrier RBs. For example, RBs of five filter banks: respectively [54, 55, 55, 55, 54] are spliced into 273 RBs, where a 100 MHz single-carrier large bandwidth is divided into five 20 MHz standard banks, which corresponds to downlink.

In summary, in the embodiments of the present disclosure, because the standard bandwidth is used, a minimum Filter Bank group can be realized, and different NR carrier bandwidth intermediate-frequency processing architectures can be built through division and reconstruction. Filters can be designed categorically, and high-order filters are used at frequency band boundaries to ensure an ACPR and a radiation module. Low-order filters are used or Window formation is performed in the middle of the frequency band, to inhibit inter-carrier interference and improve an ACPR at the far end. This reduces FFT/IFFT points and reduces processing pressure of a hard accelerator; and eases DUC/DDC processing. A structure is simpler and more consistent, and a solution architecture is unified.

As shown in Fig. 9, an embodiment of the present disclosure further provides a signal processing device applied to a downlink transmission link, including:
- a first processing unit 901, configured to process signals to be sent of various bandwidths into a plurality of groups of standard-bandwidth signals;
- a first filtering unit 902, configured to separately filter the plurality of groups of standard-bandwidth signals;
- a transmitting unit 903, configured to transmit the plurality of groups of filtered standard-bandwidth signals after combination.

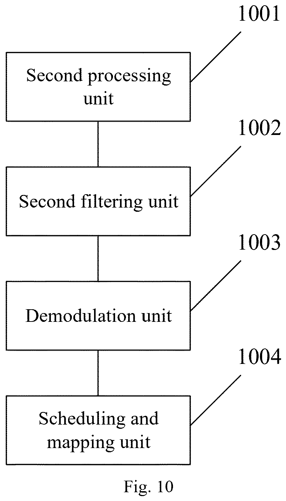

As shown in Fig. 10, an embodiment of the present disclosure further provides a signal processing device applied to an uplink transmission link, including:
- a second processing unit 1001, configured to process a received radio frequency signal into a plurality of groups of standard-bandwidth signals;
- a second filtering unit 1002, configured to separately filter the plurality of groups of standard-bandwidth signals;
- a demodulation unit 1003, configured to demodulate the plurality of groups of filtered standard-bandwidth signals;
- a scheduling and mapping unit 1004, configured to schedule and map a plurality of groups of demodulated signals obtained after demodulation.

An embodiment of the present disclosure further provides a signal processing device, including: a memory, a processor, and a computer program stored in the memory and executable by the processor, where the processor performs the signal processing method when executing the computer program.

An embodiment of the present disclosure further provides a computer-readable storage medium storing computer-executable instructions, where the computer-executable instructions are configured to perform the signal processing method.

An embodiment of the present disclosure further provides a computer-readable storage medium storing computer-executable instructions for performing the signal processing method.

In this embodiment, the above-mentioned storage medium may include, but is not limited to, various media that can store program codes, such as a USB flash drive, a read-only memory (ROM), a random access memory (RAM), a mobile hard disk, a magnetic disk or an optical disk.

It can be understood by those having ordinary skill in the art that all or some of the steps of the methods, systems and functional modules/units in the devices disclosed above can be implemented as software, firmware, hardware and appropriate combinations thereof. In the hardware implementation, the division between functional modules/units mentioned in the above description does not necessarily correspond to the division of physical components; for example, a physical component may have multiple functions, or a function or step may be performed cooperatively by several physical components. Some or all of the components may be implemented as software executed by a processor, such as a digital signal processor or a microprocessor, or as hardware, or as an integrated circuit, such as an application-specific integrated circuit. Such software can be distributed on computer-readable media, which can include computer storage media (or non-transitory media) and communication media (or transitory media). As well known to those of ordinary skill in the art, the term computer-readable storage medium includes volatile and nonvolatile, removable and non-removable media implemented in any method or technology for storing information, such as computer-readable instructions, data structures, program modules or other data. A computer-readable storage medium includes, but is not limited to, RAM, ROM, EEPROM, flash memory or other memory technologies, CD-ROM, digital versatile disk (DVD) or other optical disk storage, cassettes, magnetic tapes, magnetic disk storage or other magnetic storage devices, or any other medium that can be configured to store desired information and can be accessed by a computer. Furthermore, it is well known to those of ordinary skill in the art that communication media typically contain computer-readable instructions, data structures, program modules or other data in a modulated data signal such as a carrier wave or other transmission mechanism, and can include any information delivery media.

### INDUSTRIAL APPLICABILITY

As described above, the embodiments of the present disclosure provide a signal processing method, apparatus and device, and a computer-readable storage medium, which have the following beneficial effects: signals of various bandwidths are processed into a plurality of groups of standard-bandwidth signals, so that a DUC/DDC can adopt a unified processing architecture with high reusability and flexible scalability, thereby easing processing and reducing design redundancy of the DUC/DDC, making a structure simpler and more consistent, and reducing costs and thermal consumption of a digital intermediate frequency chip.

## Claims

1. A signal processing method, comprising:
processing signals to be sent of various bandwidths into a plurality of groups of standard-bandwidth signals;
separately filtering the plurality of groups of standard-bandwidth signals; and
transmitting the plurality of groups of filtered standard-bandwidth signals after combination.

2. The method of claim 1, wherein processing signals to be sent of various bandwidths into a plurality of groups of standard-bandwidth signals comprises:
grouping the signals to be sent of various bandwidths according to a standard bandwidth to obtain a plurality of groups of signals each having a bandwidth less than or equal to the standard bandwidth;
separately modulating the plurality of groups of signals obtained by grouping; and
stretching and aligning a modulated signal having a bandwidth less than the standard bandwidth among a plurality of groups of modulated signals obtained after modulation, such that the modulated signals are all standard-bandwidth signals.

3. The method of claim 2, wherein separately modulating the plurality of groups of signals obtained by grouping comprises:
performing an Inverse Fast Fourier Transform, IFFT, and cyclic prefix, CP, addition on the plurality of groups of signals obtained by grouping.

4. The method of claim 3, wherein
a number of IFFT points adopted to perform the IFFT is 1024 points or 2048 points.

5. The method of claim 2, wherein stretching and aligning a modulated signal having a bandwidth less than the standard bandwidth comprises:
performing an interpolation operation on the modulated signal having a bandwidth less than the standard bandwidth, to reach a sampling rate of the standard bandwidth.

6. The method of claim 1, wherein separately filtering the plurality of groups of standard-bandwidth signals comprises:
separately filtering the plurality of groups of standard-bandwidth signals by adopting filter banks, wherein a first filter bank is adopted for a standard-bandwidth signal at a boundary of a frequency band, a second filter bank is adopted for a standard-bandwidth signal in a middle of the frequency band, and the first filter bank and the second filter bank comprise filters of a same type.

7. The method of claim 6, wherein
an order of a finite impulse response, FIR, filter in the first filter bank is higher than an order of an FIR filter in the second filter bank.

8. The method of claim 6, wherein separately filtering the plurality of groups of standard-bandwidth signals comprises:
processing the standard-bandwidth signal in the middle of the frequency band by adopting the second filter bank in a time-domain windowing manner.

9. The method of claim 1, before transmitting the plurality of groups of filtered standard-bandwidth signals after combination, further comprising:
arranging the plurality of groups of filtered standard-bandwidth signals in an air-interface frequency point relationship.

10. A signal processing method, comprising:
processing a received radio frequency signal into a plurality of groups of standard-bandwidth signals;
separately filtering the plurality of groups of standard-bandwidth signals;
demodulating a plurality of groups of bandwidth signals obtained by filtering; and
scheduling and mapping a plurality of groups of demodulated signals obtained after demodulation.

11. The method of claim 10, wherein processing a received radio frequency signal into a plurality of groups of standard-bandwidth signals comprises:
performing sampling and digitization on the radio frequency signal, and dividing the radio frequency signal according to a standard bandwidth to obtain the plurality of groups of standard-bandwidth signals.

12. The method of claim 10, wherein separately filtering the plurality of groups of standard-bandwidth signals comprises:
separately filtering the plurality of groups of standard-bandwidth signals by adopting filter banks, wherein a first filter bank is adopted for a standard-bandwidth signal at a boundary of a frequency band, a second filter bank is adopted for a standard-bandwidth signal in a middle of the frequency band, and the first filter bank and the second filter bank comprise filters of the same type.

13. The method of claim 12, wherein
an order of an FIR filter in the first filter bank is higher than an order of an FIR filter in the second filter bank.

14. The method of claim 12, wherein separately filtering the plurality of groups of standard-bandwidth signals comprises:
processing the standard-bandwidth signal in the middle of the frequency band by adopting the second filter bank in a time-domain windowing manner.

15. The method of claim 10, wherein demodulating a plurality of groups of bandwidth signals obtained by filtering comprises:
performing CP removal and Fast Fourier Transform, FFT, on the plurality of groups of bandwidth signals obtained by filtering.

16. The method of claim 15, wherein
a number of FFT points adopted to perform the FFT is 1024 points or 2048 points.

17. A signal processing apparatus, comprising:
a first processing unit, configured to process signals to be sent of various bandwidths into a plurality of groups of standard-bandwidth signals;
a first filtering unit, configured to separately filter the plurality of groups of standard-bandwidth signals; and
a transmitting unit, configured to transmit the plurality of groups of filtered standard-bandwidth signals after combination.

18. A signal processing apparatus, comprising:
a second processing unit, configured to process a received radio frequency signal into a plurality of groups of standard-bandwidth signals;
a second filtering unit, configured to separately filter the plurality of groups of standard-bandwidth signals;
a demodulation unit, configured to demodulate a plurality of groups of bandwidth signals obtained by filtering; and
a scheduling and mapping unit, configured to schedule and map a plurality of groups of demodulated signals obtained after demodulation.

19. A signal processing device, comprising: a memory, a processor, and a computer program stored in the memory and executable by the processor, wherein the processor performs the signal processing method of any one of claims 1-16 when executing the computer program.

20. A computer-readable storage medium, storing computer-executable instructions, wherein the computer-executable instructions are configured to perform the signal processing method of any one of claims 1-16.
